(19) Europäisches Patentamt
European Patent Office
Office européen des brevets

(11) Veröffentlichungsnummer: **0 130 398**
**B1**

(12) # EUROPÄISCHE PATENTSCHRIFT

(45) Veröffentlichungstag der Patentschrift: **23.01.91**

(51) Int. Cl.[5]: **H 01 L 21/90**

(21) Anmeldenummer: **84106358.9**

(22) Anmeldetag: **04.06.84**

(54) **Verfahren zur Herstellung einer elektrisch leitfähigen Verbindung und Vorrichtung zur Durchführung eines solchen Verfahrens.**

(30) Priorität: **29.06.83 DE 3323434**

(43) Veröffentlichungstag der Anmeldung:
**09.01.85 Patentblatt 85/02**

(45) Bekanntmachung des Hinweises auf die Patenterteilung:
**23.01.91 Patentblatt 91/04**

(84) Benannte Vertragsstaaten:
**DE FR GB NL**

(56) Entgegenhaltungen:
**FR-A-1 031 607**
**FR-A-1 373 822**

**IBM TECHNICAL DISCLOSURE BULLETIN, Band 20, Nr. 4, September 1977, Seite 1596, New York, US; R. HAMMER; "Repair technique for eliminating discontinuities in patterned metallurgy"**

(73) Patentinhaber: **Siemens Aktiengesellschaft**
**Wittelsbacherplatz 2**
**D-8000 München 2 (DE)**

(72) Erfinder: **Rehme, Hans, Dr. Dipl.-Phys.**
**Herzog-Albrecht-Strasse 13**
**D-8011 Zorneding (DE)**

(56) Entgegenhaltungen:
**APPLIED PHYSICS LETTERS, Band 40, Nr. 9, 1. Mai 1982, Seiten 819-821, American Institute of Physics, New York, US; D. BÄUERLE et al.: "Ar+ laser induced chemical vapor deposition of Si from SiH4"**

**IEEE ELECTRON DEVICE LETTERS, Band EDL-3, Nr. 6, Juni 1982, Seiten 164-166, New York, US; J.Y. TSAO et al.: "Direct-write metallization of silicon MOSFET's using laser photodeposition"**

**EP 0 130 398 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Beschreibung**

Die Erfindung betrifft ein Verfahren zur Herstellung einer elektrisch leitfähigen Verbindung mittels strahlinduzierter chemischer Dampfabscheidung nach dem Oberbegriff des Anspruchs 1.

Zur Reparatur von integrierten Schaltungen, zur Überbrückung von Unterbrechungsstellen in Leitbahnen, zur Herstellung zusätzlicher Leitbahnen für Prüfzwecke oder zur individuellen Verdrahtung von Teilschaltungen ist jeweils eine Herstellung einer elektrisch leitfähigen Verbindung erforderlich.

Beispielsweise werden höchstintegrierte Schaltung in ihrer Entwicklungsphase mit einem Elektronenstrahl-Meßgerät geprüft. Fehler, die dabei erkannt werden, müssen durch Designänderungen eliminiert werden, die zeit- und kostenaufwendig sind. Deshalb sollte ein elektronischer Baustein vor einem geplanten Redesign in allen seinen Funktionen getestet und die Auswirkung dabei geplanter Designänderungen überprüft werden. Deswegen ist es erforderlich, daß defekte Schaltungsstrukturen repariert oder daß die Schaltung gezielt verändert wird.

Unter dem Schlagwort "micro surgery" sind einige Methoden zur Reparatur von integrierten Schaltungen bekannt. So können z.B. mit Hilfe eines Laserstrahls Leitbahnen unterbrochen werden. Um andererseits Unterbrechungsstellen zu überbrücken oder Teilschaltungen miteinander zu verbinden, müssen neue Leitbahnen erzeugt werden. Dies ist mittels zusätzlicher Lithografieschritte möglich, die jedoch entsprechend aufwendig sind. Es ist bekannt, unterbrochene Leitbahnen mit einem winzigen Tropfen eines elektrisch leitfähigen Klebers auszubessern. Dabei wird dieser elektrisch leitfähige Kleber mit einem Mikromanipulator unter mikroskopisher Kontrolle aufgebracht. Für die feinen und eng benachbarten Strukturen hochintegrierter Schaltungen ist diese Methode jedoch nicht geeignet.

Mit Hilfe der Elektronenstrahl-Lithografie wird bei einem bekannten Verfahren die gewünschte Struktur mit einem fein fokussierten Elektronenstrahl in einem strahlungsempfindlichen Lack eingeschrieben. Bei einem anderen bekannten Verfahren wird dort, wo eine zusätzliche elektrisch leitfähige Verbindung entstehen soll, eine Silberchlorid-Schicht aufgedampft. Dabei erfolgt die Belichtung durch elektronenstrahlinduzierte Dissoziation der Silberchlorid-Moleküle. Bei diesen beiden bekannten Verfahren sind mehrere Technologieschritte notwendig, die für ein kostengünstiges Reparaturverfahren nicht geeignet sind.

Für das direkte Schreiben von Schaltungsstrukturen sind Ionenstrahlschreiber und Atomstrahlschreiber vorgeschlagen worden. Solche Geräte könnten auch zum Reparieren von Schaltungen eingesetzt werden. Solche Geräte sind aber derzeit noch nicht verfügbar.

Das zur Herstellung großflächiger Schichten bekannte Verfahren der chemischen Dampfabscheidung (chemical vapor deposition: CVD) kann zur Erzeugung feiner Strukturen benutzt werden, wenn man einen fokussierten Laserstrahl zu Hilfe nimmt (LCVD). Dazu sind zwei Verfahren publiziert worden. Das eine ist eine rein thermische Methode (Pyrolyse) und beruht darauf, daß die Schichtoberfläche mit dem Laserstrahl lokal auf eine zur chemischen Abschiedung erforderliche Temperatur erhitzt wird. Damit konnten z.B. Nikkelschichten aus einer Nickel-Carbonyl-Atmosphäre bei einem Druck von 50 mbar abgeschieden werden (S.D. Allen: J. Appl. Phys. *52* (1981), 6501). Der Abscheidung liegt die Reaktion

$$Ni(CO)_4 \xrightarrow{140°} Ni + 4\,CO \qquad (1)$$

zugrunde. Die Wachstumsrate beträgt z.B. 60 µm/min bei einer Laserleistung von 0,5 W und einem Strahldurchmesser von 0,6 mm (Leistungsdichte 170 $W/cm^2$).

Bei der anderen LCVD-Methode (T. F. Deutsch, D. J. Ehrlich, R. M. Osgaad, Jr.: Appl. Phys. Lett. *35* (1979), 175) werden mit Hilfe eines UV-Lasers die Molekülbindungen des Reaktionsgases aufgebrochen und freie Metallatome erzeugt, die auf dem Substrat kondensieren (Photolyse). Auf diese Weise war es möglich, Metallschichten aus Metall-Alkyl-Verbindungen abzuscheiden, z.B. Aluminium aus Trimethylaluminium $Al(CH_3)_3$ oder Kadmium aus Dimethylkadmium $Cd(CH_3)_2$. Die Versuchsbedingungen waren: 400 Pa (4 mbar) Metall-Alkyl-Gas, gepuffert mit 100 kPa (1000 mbar) Helium; 0,1...1 $W/cm^2$ Laser-Leistungsdichte; 1...60 s Expositionszeit. Es konnten Schichten bis zu 0,6 µm Dicke sowie Strukturen im Submikronbereich erzeugt werden.

Die LCVD-Verfahren sind sicherlich auch geeignet, Fehler in integrierten Schaltungen zu reparieren. Allerdings muß der betreffende Baustein nach der Prüfung in einem Testgerät bzw. in einem Elektronenstrahl-Meßgerät (EMG) in eine besondere Apparatur gebracht werden, in der er der Atmosphäre des Reaktionsgases (z.B. metallorganische Verbindungen oder Metall-Halogenid) ausgesetzt wird. Die exakte Positionierung des Laserstrahls auf die defekte Stelle sowie die zur Erzeugung einer bestimmten Verbindung erforderliche Führung des Laserstrahls oder der Probe stellen zusätzliche Probleme dar.

Aus der FR—A—1 031 607 ist ein Verfahren zur pyrolytischen oder photolytischen Abscheidung eines Metalls auf einer von einem Elektronen- oder Ionenstrahl aufgeheizten Probe bekannt. Das Reaktionsgas wird hierbei mit Hilfe einer Kanüle an den zu beschichtenden Bereich herangeführt.

Der vorliegenden Erfindung liegt die Aufgabe zugrunde, ein Verfahren der eingangs genannten Art anzugeben, mit dem eine Struktur von elektrischen Verbindungen in einfacher Weise geändert werden kann.

Diese Aufgabe wird erfindungsgemäß durch ein Verfahren nach Patentanspruch 1 gelöst.

Ausgestaltungen und Vorteile der Erfindung sind in den Unteransprüchen, der Beschreibung und der Zeichnung dargestellt.

Eine erfindungsgemäße elektronenstrahlinduzierte chemische Dampfabscheidung (ECVD) kann während der Überprüfungsphase einer integrierten Schaltung in einem Elektronenstrahl-Meßgerät durchgeführt werden. Dazu können der Elektronenstrahl und ein aus einer Kanüle strömendes Reaktionsgas, z.B. eine metall-organische Verbindung oder eine aus Metallkomplexen bestehende chemische Verbindung gleichzeitig auf diejenige Stelle gerichtet werden, an der die Dampfabscheidung erfolgen soll. Dabei kann eine Kanüle oder Düse im Elektronenstrahl-Meßgerät unter elektronenmikroskopischer Kontrolle justiert werden. Die Dampfscheidung kann dabei elektrisch kontrolliert und gesteuert werden.

Mit einem erfindungsgemäßen Verfahren kann die Verdrahtung in der obersten Leitbahnebene eines elektronischen Bausteines ohne Zeitverzug geändert werden. Die Erfindung ermöglicht es, solche Änderungen während der elektrischen Überprüfung eines elektronischen Bausteines in einem Elektronenstrahl-Meßgerät vorzunehmen. Solche Änderungen können dazu dienen, eine integrierte Schaltung zu reparieren, zu ändern oder Teilschaltungen miteinander zu verbinden. Zum Durchtrennen von Leitbahnen kann zusätzlich ein Laser an ein Elektronenstrahlgerät adaptiert werden.

Die Erfindung wird im folgenden anhand der Zeichnung näher erläutert.

Die Figur zeigt schematisch eine Anordnung für eine erfindungsgemäß elektronenstrahlinduzierte chemische Dampfabscheidung.

Eine elektrisch leitfähige Leitbahn AL, beispielsweise aus Aluminium, befindet sich auf einer Oxidschicht O. Unterhalb dieser Oxidschicht O befindet sich beispielsweise ein Siliziumsubstrat S. Die elektrisch leitfähig Leitbahn AL weise eine Leitbahnunterbrechung D auf. Der Elektronenstrahl EB eines Elektronenstrahlgerätes ist auf diejenige Stelle gerichtet, an der sich die Leitbahnunterbrechung D befindet. Durch eine Kanüle K wird ein Reaktionsgas V hindurchgeführt. Ein Ende dieser Kanüle K ist auf denjenigen Bereich positioniert, in dem sich diejenige Stelle befindet, an der die elektrisch leitfähige Leitbahn AL die Leitbahnunterbrechung D aufweist.

Mit einer Vorrichtung nach der Figur läßt sich ein Verfahren durchführen, mit dem eine defekte Schaltung während der Überprüfung ihrer elektrischen Eigenschaften in einem Elektronenstrahl-Meßgerät mit Hilfe des Elektronenstrahles EB unter elektronenmikroskopischer Kontrolle repariert werden kann. In Analogie zur laserinduzierten chemischen Dampfabscheidung (LCVD) handelt es sich dabei um eine elektronenstrahlinduzierte chemische Dampfabscheidung (ECVD). Bei Verwendung eines Elektronenstrahles EB müssen besondere Vorkehrungen getroffen bzw. Bedingungen eingehalten werden.

Ein Elektronenstrahlgerät enthält empfindliche, elektroneoptische Bauteile wie z.B. die Polschuhe der elektromagnetischen Linsen, die vor Korrosion geschützt werden müssen. Daher müssen für das Reaktionsgas V solche chemische Verbindungen verwendet werden, die nach der Zersetzung nicht-korrosive, gasförmige Komponenten bilden. Dafür kommen z.B die metall-organischen Verbindungen wie z.B. Trimethylaluminium in Frage. Ebenso kommen jedoch auch Metallkomplexe wie z.B. Nickel-Tetrakarbonyl in Betracht.

Da ein Elektronenstrahlgerät unter Hochvakuum arbeiten muß, kann die Apparatur nicht mit dem für die Dampfabscheidung notwendigen Gasdruck betrieben werden. Statt dessen wird gemäß der Erfindung das Reaktionsgas V durch eine sehr feine, regulierbare und positionierbare Düse oder Kanüle K zugeführt. Ein Ende dieser Kanüle K soll vor dem Gaseinlaß des Reaktionsgases V unter elektronenmikroskopischer Kontrolle unmittelbar an diejenige Stelle D herangeführt werden, an der die Dampfabscheidung erfolgen soll.

Durch gute Vakuumbedingungen in der Probenkammer des Elektronenstrahlgerätes wird dafür gesorgt, daß die nicht umgesetzten Anteile des Reaktionsgases V sowie die nach der Reaktion freigesetzten Komponenten des Reaktionsgases V rasch und sicher abgepumpt werden. Durch eine Druckstufe, d.h. eine enge Blende BL oberhalb der Probenkammer, wird ferner gewährleistet, daß die elektronenmikroskopische Säule vom Vorgang der elektronenstrahlinduzierten chemischen Dampfabscheidung unbeeinflußt bleibt.

Bei der Beschreibung der laserinduzierten chemischen Dampfabscheidung (LCVD) wurden oben zwei Verfahren erwähnt, nämlich einmal eine rein thermische Methode (Pyrolyse) und zum anderen eine Methode, bei der die Molekülbindungen des Reaktionsgases V aufgebrochen und freie Metallatome erzeugt werden, die auf dem Substrat kondensieren (Photolyse). Diese beiden Methoden eignen sich auch zur Durchführung eines erfindungsgemäßen Verfahrens zur elektronenstrahlinduzierten chemischen Dampfabscheidung (ECVD). Zur Durchführung einer Pyrolyse muß diejenige Stelle, an der mit einem erfindungsgemäßen Verfahren eine elektrisch leitfähige Verbindung hergestellt werden soll, im allgemeinen auf eine Temperatur aufgeheizt werden, die über der Zimmertemperatur liegt. Zur bloßen Durchführung einer Photolyse muß diejenige Stelle, an der mit einem erfindungsgemäßen Verfahren eine elektrisch leitfähige Verbindung hergestellt werden soll, nicht unbedingt aufgeheizt werden. Auch unter Elektronenbeschuß findet eine Zersetzung der Gasmoleküle des Reaktionsgases V schon bei Zimmertemperatur statt. Aus diesem Sachverhalt resultieren z.B. die allgemein bekannten, unangenehmen "Kontaminationsschichten", die aus den Kohlenwasserstoff-Anteilen des Restgases, das sich noch jeweils im Elektronenstrahlgerät befindet, niedergeschlagen werden. Um zusammenhängende, elektrisch gut leitfähige Verbindungen zu erhalten, sind aber Temperaturen über 100°C, insbesondere um 200°C herum, besonders geeignet. Deshalb ist es für die Pyrolyse notwendig und für

die Photolyse besonders vorteilhaft, diejenige Stelle, an der eine elektrisch leitfähige Verbindung hergestellt werden soll, auf etwa 200°C aufzuheizen.

Die Temperaturerhöhung am Auftreffort D des Elektronenstrahles EB gegenüber der Umgebung beträgt

$$\Delta T \approx \frac{\dot{Q}_o}{2\lambda R} = \frac{f I_o U_o}{2\lambda R}. \qquad (2)$$

Hier bedeuten $Q_o$ die auf die Probe fallende Wärmeleistung, λ die Wärmleitfähigkeit am Auftreffort des Elektronenstrahls EB, R die Eindringtiefe der Elektronen in der Probe, f den Bruchteil der in Wärme umgesetzten elektrischen Leistung, $I_o$ die Stromstärke des Elektronenstrahles EB und $U_o$ die Beschleunigungsspannung, der der Elektronenstrahl EB ausgesetzt ist.

Bei empfindlichen Schaltungen muß zur Vermeidung von Strahlenschädigungen bei niedrigen Beschleunigungsspannungen gearbeitet werden. Deshalb wird $U_o$=2,5 kV angenommen. Die Eindringtiefe R der Elektronen in der Probe beträgt in diesem Falle etwa 0,1 µm. Für Siliziumdioxid als Unterlage O für eine zu erzeugende Leitbahn AL beträgt die Wärmeleitfähigkeit $\lambda = 10^{-2}$ W/cm K und der Bruchteil f der in Wärme umgesetzten elektrischen Leistung beträgt etwa 0,8 weil der Rückstreukoeffizient η für Siliziumdioxid etwa 0,2 beträgt. Mit diesen Werten und mit einer Temperaturdifferenz ΔT von 200°C erhält man eine erforderliche Stromstärke $I_o$ des Elektronenstrahles EB von etwa $2 \cdot 10^{-8}$ A. Dieser Wert für die Stormstärke $I_o$ des Elektronenstrahles EB ist ein in einem Elektronenstrahl-Meßgerät üblicher Wert, mit dem sich ein Strahldurchmesser von weniger oder gleich einem Mikrometer, wie er für die elektronenstrahlinduzierte chemische Dampfabscheidung (ECVD) benötigt wird, ohne Schwierigkeiten erzielen läßt. Gegebenenfalls muß nach Durchführung einer Elektronenstrahlmessung, die üblicherweise bei einer Beschleunigungsspannung $U_o$ des Elektronenstrahles EB von 2,5 kV durchgeführt wird, die Stromstärke $I_o$ des Elektronenstrahles EB auf den für die elektronenstrahlinduzierte chemische Dampfabscheidung (ECVD) erforderlichen Wert erhöht werden.

Wenn ein Stück Leitbahn von 10 µm und 2 µm Breite erzeugt werden soll, dann muß mit dem Elektronenstrahl EB eine 20 µm² große Fläche abgetastet werden, auf die sich die Leistung des Elektronenstrahles EB verteilt. Mit den oben angegebenen Werten für die Beschleunigungsspannung $U_o$ von 2,5 kV und für die Stromstärke $I_o$ des Elektronenstromes von $2 \cdot 10^{-8}$ A beträgt die mittlere Leistungsdichte des Elektronenstrahles EB 250 W/cm², was deutlich über dem von S. D. Allen in seiner oben zitierten Veröffentlichung angegebenen Wert für die mittlere Leistungsdichte für die thermische laserinduzierte chemische Dampfabscheidung (Pyrolyse) liegt. Bei der Pyrolyse von Nickel-Tetrakarbonyl bei einer Temperatur von etwa 200° an denjenigen Stellen, an denen eine elektrisch leitfähige Verbindung hergestellt werden soll, mit Hilfe einer elektronenstrahlinduzierten chemischen Dampfabscheidung gemäß der Erfindung sind somit praktikable Schichtdikken zu erwarten.

Für den Fall, daß ein Stück Aluminium-Leitbahn AL von 10 µm Länge, 2 µm Breite und 1 µm Höhe mittels Photolyse aus Trimethylaluminium abgeschieden werden soll, sind dafür $10^{12}$ Al-Atome erforderlich. Dies bedeutet, daß auch $10^{12}$ Trimethylaluminium-Moleküle mittels Photolyse zersetzt werden müssen.

Trimethylaluminium ist unter Normalbedingungen eine Flüssigkeit (wie die meisten metallorganischen Verbindungen) mit einer Dichte von 0,75 g/cm³. Nimmt man an, daß die Ausbeute bei der Photolyse zwischen $10^{-3}$ und $10^{-8}$ liegt, dann müssen während der elektronenstrahlinduzierten chemischen Dampfabscheidung zwischen $10^{15}$ und $10^{20}$ Trimethylaluminium-Moleküle denjenigen Stellen, an denen die elektrisch leitfähige Verbindung hergestellt werden soll, zugeführt werden. Dies entspricht unter Normalbedingungen einer Menge zwischen $10^{-7}$ und $10^{-2}$ cm³ Flüssigkeit. Eine für die elektronenstrahlinduzierte chemische Dampfabscheidung praktikable Zeit ist 10 sec. Dann liegt die Rate für die Gaszufuhr des Reaktionsgases V zwischen $10^{-4}$—10 Pa dm³/s ($10^{-6}$ und $10^{-1}$ mbar dm³/s) (zum Vergleich: Die Dichtheit eines Ventils wird zu kleiner $10^{-7}$ Pa dm³/s ($10^{-9}$ mbar dm³/s) angegeben. Für Lecksucher werden Testlecks mit $5 \cdot 10^{-3}$ Pa dm³/s ($5 \cdot 10^{-2}$...$10^{-5}$ mbar dm³/s) angeboten).

Die chemische Substanz, aus der das Reaktionsgas V besteht, kann entweder direkt als Flüssigkeit durch die Kanüle K in das Vakuum eingelassen oder vorher in einem Vorvakuum-Gefäß in den gasförmigen Zustand übergeführt werden.

Durch rasterelektronenmikroskopische Abbildung in einem Elektronenstrahlgerät kann die zu reparierende Stelle einer Schaltung auf dem Bildschirm des Elektronenstrahlgerätes sichtbar gemacht werden. Da Abbildung und Dampfabscheidung von ein und demselben Elektronenstrahl EB bewirkt werden, ist eine exakte Positionierung (mit einer durch den Strahldurchmesser des Elektronenstrahles EB gegebenen Unsicherheit von weniger als 1 µm) von vornherein gegeben.

Während der elektronenstrahlinduzierten chemischen Dampfabscheidung ist es zweckmäßig, die gegenseitige Position von Elektronenstrahl EB und Kanüle K nicht wesentlich zu verändern. Deshalb sollte statt des Elektronenstrahles EB besser die Probe bewegt werden, wenn längere Stücke einer Leitbahn AL produziert werden sollen. Da moderne Elektronenstrahl-Meßgeräte mit einem rechnergesteuerten Probentisch ausgerüstet sind, kann die Probe auf einem vor der Dampfabscheidung festgelegten und programmierten Weg mit vorgegebener, an den Prozeß der elektronenstrahlinduzierten chemischen Dampfabscheidung angepaßten Geschwindigkeit bewegt werden.

Das Ergebnis der elektronenstrahlinduzierten chemischen Dampfabscheidung kann während der Dampfabscheidung oder unmittelbar danach durch rasterelektronenmikroskopische Abbildung (Beispiel: Probenstromabbildung) sichtbar gemacht werden. Da die integrierte Schaltung im Elektronenstrahl-Meßgerät kontaktiert ist, lassen sich darüber hinaus das Ergebnis der Dampfabscheidung auch elektrisch kontrollieren und der Vorgang dieser Dampfabscheidung steuern.

Ein Elektronenstrahl-Meßgerät, das zur Durchführung eines erfindungsgemäßen Verfahrens geeignet ist, ist beispielsweise aus der US-Patentschrift 4 277 679 bekannt.

## Patentansprüche

1. Verfahren zur Herstellung einer elektrisch leitfähigen Verbindung mittels strahlinduzierter chemischer Dampfabscheidung in einem Elektronenstrahlgerät, bei dem ein Elektronenstrahl (EB) auf den für die Dampfabscheidung vorgesehenen Bereich (D) einer Probe (Al, O, S) gerichtet wird und bei dem ein Reaktionsgas (V) unter Verwendung einer Kanüle (K) oder Düse an den Bereich (D) herangeführt wird, dadurch gekennzeichnet, daß eine rasterelektronenmikroskopische Abbildung des Bereichs (D) mit dem zur Dampfabscheidung verwendeten Elektronenstrahl (EP) vorgenommen wird.

2. Verfahren nach Anspruch 1, dadurch gekennzeichnet, daß das Reaktionsgas (V) durch Verdampfung einer mittels der Kanüle (K) in das Vakuum des Elektronenstrahlgeräts eingebrachten chemischen Substanz erzeugt wird.

3. Verfahren nach Anspruch 1 oder 2, dadurch gekennzeichnet, daß eine metall-organische Verbindung als Reaktionsgas (V) verwendet wird.

4. Verfahren nach einem der Ansprüche 1 bis 3, dadurch gekennzeichnet, daß eine aus Metallkomplexen bestehende chemische Verbindung als Reaktionsgas (V) verwendet wird.

5. Verfahren nach einem der Ansprüche 1 bis 4, dadurch gekennzeichnet, daß der Bereich (D) mit dem Elektronenstrahl (EB) auf eine Temperatur von etwa 200°C aufgeheizt wird.

6. Verfahren nach einem der Ansprüche 1 bis 5, dadurch gekennzeichnet, daß die Probe (Al, O, S) relativ zum Elektronenstrahl (EB) und zur Kanüle (K) bewegt wird.

7. Verwendung des Verfahrens nach einem der Ansprüche 1 bis 6 in einem Elektronenstrahlmeßgerät zur Herstellung einer elektrisch leitfähigen Verbindung bei der Prüfung von hochintegrierten Schaltungen.

8. Vorrichtung zur Durchführung des Verfahrens nach einem der Ansprüche 1 bis 6, gekennzeichnet durch ein Elektronenstrahlgerät, das eine elektromagnetische Linsen enthaltende elektronenmikroskopische Säule, eine evakuierte Probenkammer, einen Probentisch, einen Bildschirm zur Darstellung des rasterelektronenmikroskopischen Bildes des Bereichs (D) sowie eine auf der Probe positionierbare Einrichtung (K) zum Heranführen des Reaktionsgases (V) an den Bereich (D) aufweist.

9. Vorrichtung nach Anspruch 8, dadurch gekennzeichnet, daß die Einrichtung (K) eine regulierbare Öffnung zum Austritt des Reaktionsgases (V) aufweist.

10. Vorrichtung nach Anspruch 8 oder 9, gekennzeichnet durch eine zwischen der Probenkammer und der elektronenmikroskopischen Säule angeordnete Druckstufe (BL).

## Revendications

1. Procédé pour réaliser une liaison électroconductrice par un dépôt chemique en phase vapeur induit par un rayonnement dans un appareil à bombardement électronique, dans lequel le jet électronique (EB) est dirigé sur la zone (D) d'un échantillon (Al, O, S) qui est prévue pour le dépôt en phase vapeur, et dans lequel un gaz réactionnel (V) est amené à ladite zone, avec mise en oeuvre d'une canule (K) ou d'une tuyère, caractérisé par le fait que l'on procède, avec le jet électronique (EP) utilisé pour le dépôt en phase vapeur, à une reproduction au microscope électronique de balayage de la zone (D).

2. Procédé selon la revendication 1, caractérisé par le fait que le gaz réactionnel (V) est produit par évaporation d'une substance chimique introduite à l'aide de la canule (K) dans l'espace évacué de l'appareil à bombardement électronique.

3. Procédé selon la revendication 1 ou 2, caractérisé par le fait que l'on utilise comme gaz réactionnel (V) un composé métallo-organique.

4. Procédé selon l'une des revendications 1 à 3, caractérisé par le fait que l'on utilise comme gaz réactionnel (V) un composé chimique constitué par des complexes métalliques.

5. Procédé selon l'une des revendications 1 à 4, caractérisé par le fait que la zone (D) est chauffée, avec le jet électronique (EB), à une température d'environ 200°C.

6. Procédé selon l'une des revendications 1 à 5, caractérisé par le fait que l'échantillon (Al, O, S) est déplacé par rapport au jet électronique (EB) et par rapport à la canule (K).

7. Mise en oeuvre du procédé selon l'une des revendications 1 à 6 dans un appareil de mesure à bombardement électronique pour réaliser une liaison électroconductrice lors du contrôle de circuits à haute densité d'intégration.

8. Dispositif pour la mise en oeuvre du procédé selon l'une des revendications 1 à 6, caractérisé par un appareil à bombardement électronique qui comporte une colonne d'électromicroscope comportant une lentille électromagnétique, une chambre d'échantillon évacuée, une table d'échantillon, un écran pour visualiser l'image formée par un microscope électronique à balayage de la zone (D), ainsi qu'un dispositif (K) susceptible d'être positionné sur l'échantillon pour amener le gaz réactionnel (V) au niveau de la zone (D).

9. Dispositif selon la revendication 8, caractérisé par le fait que le dispositif (K) comporte une ouverture réglable pour la sortie du gaz réactionnel (V).

10. Dispositif selon la revendication 8 ou 9,

caractérisé par un étage de pression (BL) disposé entre la chambre d'échantillon et la colonne à microscope électronique.

**Claims**

1. Method for producing an electrically conductive connection by means of beam-induced chemical vapour deposition in an electron beam apparatus, in which method an electron beam (EB) is directed at the region (D) of a specimen (Al, O, S) intended for the vapour deposition and in which method a reaction gas (V) is fed to the region (D) using a hollow needle (K) or nozzle, characterized in that a scanning electron microscope image of the region (D) is produced with the electron beam (EP) used for the vapour deposition.

2. Method according to Claim 1, characterized in that the reaction gas (V) is produced by evaporating a chemical substance introduced by means of the hollow needle (K) into the vacuum of the eletron beam apparatus.

3. Method according to Claim 1 or 2, characterized in that an organometallic compound is used as reaction gas (V).

4. Method according to one of Claims 1 to 3, characterized in that a chemical compound composed of metal complexes is used as reaction gas (V).

5. Method according to one of Claims 1 to 4, characterized in that the region (D) is heated to a temperature of about 200°C with the electron beam (EB).

6. Method according to one of Claims 1 to 5, characterized in that the specimen (Al, O, S) is moved relative to the electron beam (EB) and to the hollow needle (K).

7. Use of the method according to one of Claims 1 to 6 in an electron beam measuring apparatus for producing an electrically conductive compound in the testing of large-scale integrated circuits.

8. Apparatus for carrying out the method according to one of Claims 1 to 6, characterized by an electron beam apparatus which comprises an electron microscope column containing electromagnetic lenses, an evacuated specimen chamber, a specimen stage, a display screen for displaying the scanning electron microscope image of the region (D) and also a device (K), which can be positioned on the specimen, for feeding the reaction gas (V) to the region (D).

9. Apparatus according to Claim 8, characterized in that the device (K) comprises a regulable opening for the discharge of the reaction gas (V).

10. Apparatus according to Claim 8 or 9, characterized by a pressure stage (BL) disposed between the specimen chamber and the electron microscope column.

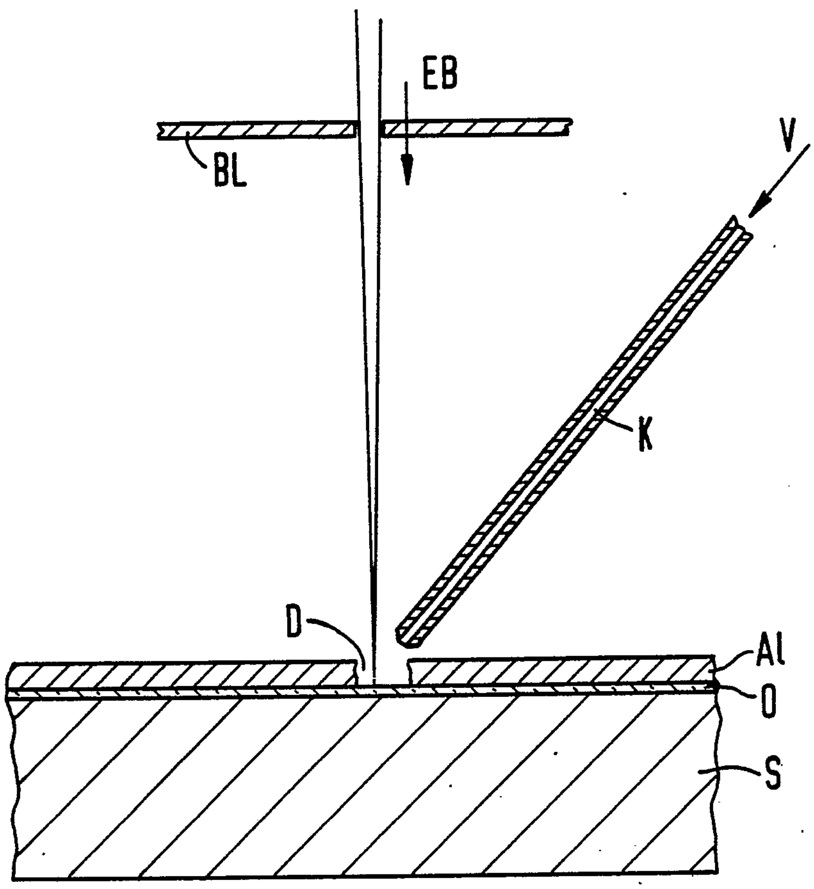
EB
BL
V
K
D
Al
O
S